# FASCICULE DE BREVET EUROPEEN

(11) **EP 2 630 664 B1**
(45) Date de publication et mention de la délivrance du brevet: **30.12.2015**
(21) Numéro de dépôt: 11832093.6
(22) Date de dépôt: 10.10.2011
(51) Int. Cl.: H01L 31/032, H01L 31/0264, C25D 21/12, C25D 5/10, C25D 7/06, H01L 21/02

(54) **CONTRÔLE DE LA STOECHIOMÉTRIE DE COUCHES I-III-VI POUR DES APPLICATIONS PHOTOVOLTAÏQUES À PARTIR DE CONDITIONS D'ÉLECTROLYSE PERFECTIONNÉES.**
PRÜFUNG DER STÖCHIOMETRIE VON I-III-VI-SCHICHTEN ZUR VERWENDUNG IN DER PHOTOVOLTAIK DURCH VERBESSERTE ELEKTROLYSEBEDINGUNGEN
CHECKING THE STOICHIOMETRY OF I-III-VI LAYERS FOR USE IN PHOTOVOLTAICS USING IMPROVED ELECTROLYSIS CONDITIONS

(30) Priorité: 18.10.2010 FR 1058457
(43) Date de publication de la demande: 28.08.2013
(73) Titulaire: Nexcis, 13106 Rousset (FR)
(72) Inventeur: GRAND, Pierre-Philippe, F-13106 Rousset (FR); JAIME, Salvador, F-13106 Rousset (FR); DE GASQUET, Philippe, F-13106 Rousset (FR); DELIGIANNI, Hariklia, Yorktown Heights, NY 10598 (US); ROMANKIW, Lubomyr, T., Yorktown Heights, NY 10598 (US); VAIDYANATHAN, Raman, Yorktown Heights, NY 10598 (US); HUANG, Qiang, Yorktown Heights, NY 10598 (US); AHMED, Shafaat, Yorktown Heights, NY 10598 (US)
(74) Mandataire: Cabinet Plasseraud
(86) Numéro de dépôt international: PCT/FR2011/052363
(87) Numéro de publication internationale: WO 2012/052657

(56) Documents cités:
- WO-A1-2010/111927
- FR-A1- 2 839 201
- FR-A1- 2 849 532
- US-A- 4 581 108
- US-A- 5 312 532
- US-A- 5 516 412
- US-A1- 2005 006 241
- H.S. Ullal ET AL: "Thin Film CIGS and CdTe Photovoltaic Technologies: Commercialization, Critical Issues, and Applications", , 3 September 2007 (2007-09-03), XP055182160, Retrieved from the Internet: URL:http://www.nrel.gov/pv/pdfs/42058.pdf [retrieved on 2015-04-10]

## Description

L'invention concerne le domaine de la fabrication de composés I-III-VI à propriétés photovoltaïques, sous forme de couche mince.

Dans de tels composés, de stoechiométrie voisine de I-III-VI₂, l'élément I de la première colonne de la table périodique des éléments peut être du cuivre (ou encore de l'argent, ou encore un mélange de ces éléments), l'élément III de la troisième colonne peut être de l'indium, du gallium, de l'aluminium ou un mélange de ces éléments, et l'élément VI de la sixième colonne peut être du sélénium, du soufre ou un mélange de ces éléments. Un tel composé présente globalement une structure cristallographique de type chalcopyrite.

Ce composé présente en particulier d'excellentes propriétés photovoltaïques. Il est alors intégré sous forme de couche mince, active, dans des cellules photovoltaïques, notamment dans des panneaux solaires.

Les techniques de dépôt d'une telle couche mince, sur substrat, sont diverses. Il peut s'agir d'un dépôt physique (par exemple par pulvérisation d'une cible), ou d'un dépôt chimique. La présente invention concerne cette deuxième technique de dépôt et en particulier la technique de dépôt par électrolyse. Le substrat (par exemple une couche mince de molybdène sur verre) devant recevoir le dépôt de la couche mince est prévu en tant qu'électrode immergée dans un bain d'électrolyse comportant des sels d'élément I et/ou d'élément III et/ou d'élément VI. Une tension est appliquée à l'électrode (par rapport à une électrode de référence au sulfate mercureux) pour initier le dépôt. Toutefois, de tels bains sont réputés instables à cause de la présence de l'élément VI dans le bain. Ainsi, il pourrait être envisagé de faire croître une couche de stoechiométrie globale voisine de I-III par exemple et traiter ensuite la couche obtenue par apport ultérieur d'élément VI. Toutefois, ici encore, la croissance de la couche I-III par électrolyse peut s'avérer instable et en particulier le contrôle de la stoechiométrie de l'alliage I-III dans la couche finale n'est pas assuré.

Il est donc préféré actuellement de déposer une structure multicouche selon une séquence de couches élémentaires (par exemple une couche d'élément I, puis une couche d'élément III, puis éventuellement une nouvelle couche d'élément I et une couche d'élément III, etc.), puis d'appliquer un traitement thermique (typiquement un recuit selon une séquence choisie d'élévation en température, de maintien en température et d'abaissement en température) pour obtenir une structure « inter-mixée », donc mélangée, de stoechiométrie globale I-III.

L'apport en élément VI peut être réalisé ultérieurement (par traitement thermique de sélénisation et/ou sulfuration) ou en même temps que le recuit précité pour obtenir la stoechiométrie désirée I-III-VI₂.

Les couches obtenues présentent des propriétés photovoltaïques satisfaisantes, en procurant ainsi de bons rendements aux cellules photovoltaïques intégrant de telles couches minces.

Toutefois, dans des cellules obtenues par ce type de dépôt par électrolyse, il a été observé des problèmes de transport électronique liés à des inhomogénéités de la couche à propriétés photovoltaïques.

US4581108 divulgue la formation de couches minces CIS pour panneau photovoltaïques par électrodéposition.

La présente invention vient améliorer la situation.

Elle propose à cet effet un procédé de fabrication d'un composé I-III-VI pour des applications photovoltaïques, sous forme de couche mince (où l'élément I désigne typiquement le cuivre, l'élément III désigne l'indium et/ou le gallium et l'élément VI désigne le soufre et/ou le sélénium). Ce procédé comprend les étapes :
a) électro-déposer une structure de couche mince d'éléments I et/ou III sur la surface d'une électrode, et
b) incorporer au moins un élément VI dans la structure pour obtenir le composé I-III-VI.

Au sens de l'invention, l'étape d'électro-dépôt a) comporte un contrôle d'épaisseur de couche mince à moins de 3% de variation en uniformité d'épaisseur sur toute la surface de l'électrode recevant le dépôt.

Il s'est avéré que cette caractéristique de contrôle d'épaisseur sur toute la surface du dépôt était particulièrement avantageuse pour le bon fonctionnement d'une cellule solaire comportant une telle structure de couche.

En outre, comme présenté ci-avant, la structure de couche mince I-III peut être (possiblement mais non limitativement) obtenue par dépôts successifs de couches élémentaires, d'éléments I et III. Le contrôle de l'épaisseur de chaque couche élémentaire est crucial pour un bon contrôle de la stoechiométrie I-III (pour obtenir finalement la stoechiométrie désirée I-III-VI₂). Le contrôle de la stoechiométrie sur toute la surface de la structure de couche est aussi un paramètre important pour le bon fonctionnement d'une cellule solaire comportant une telle structure de couche.

Ainsi, dans le cas où la structure de couche mince comporte une succession de couches élémentaires d'au moins les éléments respectifs X et Y, X étant un élément parmi les éléments I et III et Y étant l'autre des éléments I et III, il est particulièrement avantageux que l'étape d'électro-dépôt comporte un contrôle d'épaisseurs respectives des couches élémentaires à moins de 3% de variation en uniformité d'épaisseur, pour un contrôle de la stoechiométrie en élément I par rapport à l'élément III avec moins de 4% de variation en stoechiométrie en élément I par rapport à l'élément III, sur toute la surface de la structure de couche.

Cette caractéristique avantageuse a été constatée sur des électrodes (ou « substrats ») de grandes dimensions, typiquement supérieures ou de l'ordre de 700 cm² (par exemple 30 cm sur 60 cm).

Ces résultats satisfaisants peuvent être atteints aussi bien avec des couches élémentaires I et III tels qu'à base respectivement de cuivre (Cu) et d'indium (In), qu'avec des empilements à plus de deux couches élémentaires. Par exemple, la structure de couche mince peut comporter au moins une troisième espèce élémentaire Z (par exemple du gallium Ga), intervenant en tant qu'élément III dans la composition I-III-VI. Ainsi, la composition I-III, avant traitement thermique et apport d'élément VI, peut être par exemple de type :
- Cu-In, ou encore In-Cu,
- mais encore de type Cu-In-Ga, ou encore Cu-Ga-In.

Il peut être avantageux de déposer l'élément III (par exemple l'indium) avant l'élément I, auquel cas, la composition I-III peut être par exemple :
- In-Ga-Cu, ou encore In-Cu-Ga,
- ou, dans une variante où l'élément Ga est déposé en premier, Ga-In-Cu ou encore Ga-Cu-In.

Il est à noter néanmoins que des essais ont été réalisés aussi avec une couche élémentaire de cuivre Cu et une couche d'alliage binaire d'indium-gallium (In-Ga). Le contrôle d'épaisseur de chaque couche a permis d'atteindre, là encore, une stoechiométrie I-III avec une variation de moins de 4% sur toute la surface de la structure de couche.

Dans l'un quelconque des cas présentés ci-dessus, l'étape b) peut comporter une étape préalable de recuit pour inter-mixer les couches élémentaires de la structure multicouche et obtenir finalement une couche d'alliage I-III de stoechiométrie respectée.

Plus généralement, des essais ont été menés aussi pour le dépôt d'une couche I-III (par exemple à partir de sels de cuivre et d'indium présents ensemble dans le bain d'électrolyse, ou même des trois espèces cuivre, indium et gallium présentes dans le bain) et il a été obtenu directement une couche I-III (sans passer par l'empilement de couches élémentaires I et III) dont l'épaisseur était encore contrôlée à moins de 3% de variation sur toute la surface de cette couche I-III (la variation de stoechiométrie restant inférieure à 4%, en tout état de cause). Ainsi, la présente invention vise tant une application à des structures multicouches qu'une application pour une monocouche I-III.

En outre, il a été observé que l'épaisseur, la stoechiométrie, mais aussi l'homogénéité des dépôts, sont respectées par la mise en oeuvre de l'invention, autant à l'échelle macrométrique qu'à l'échelle nanométrique.

Ainsi, l'étape d'électro-dépôt comporte en outre un contrôle d'homogénéité à une échelle nanométrique de la structure de couche mince sur toute la surface du substrat recevant le dépôt.

En particulier, la structure de couche présente une rugosité de grains inférieure ou de l'ordre de 50 nanomètres. Des essais présentés ci-après montrent en particulier qu'une couche d'élément III à titre d'exemple, électrodéposée par le procédé au sens de l'invention, présente avantageusement une rugosité de grains de dimension moyenne inférieure ou de l'ordre de 50 nanomètres.

Un moyen avantageux pour atteindre de telles caractéristiques consiste à prévoir en particulier des moyens d'agitation du bain d'électrolyse dans lequel est plongé le substrat pour recevoir le dépôt. Ainsi, l'étape d'électro-dépôt comporte préférentiellement une opération de balayage mécanique d'un agitateur de bain d'électrolyse, devant la surface du substrat.

Dans une réalisation particulière, l'agitateur se déplace selon un mouvement rectiligne de va-et-vient parallèlement à la surface du substrat.

Selon des essais réalisés ayant donné des résultats satisfaisants décrits plus en détails ci-après, l'agitateur comporte préférentiellement une section en coupe présentant au moins deux triangles inversés, la base du triangle le plus proche du substrat étant parallèle à la surface du substrat. Une telle forme d'agitateur permet d'atteindre de telles caractéristiques d'uniformité sur des substrats de dimensions aussi grandes que 700 cm², ainsi que les caractéristiques précitées d'homogénéité à l'échelle nanométrique. L'utilisation d'un tel moyen est particulièrement simple et robuste pour une mise en oeuvre à l'échelle industrielle sur des substrats de grandes dimensions.

Ainsi, par la mise en oeuvre de l'invention, la variation d'épaisseur reste avantageusement inférieure à 3% et ce sur toute la surface de la couche. La présente invention vise alors un composé I-III-VI pour des applications photovoltaïques, sous forme de couche mince, obtenu par le procédé au sens de l'invention, et comportant en particulier moins de 3% de variation en uniformité d'épaisseur sur toute la surface de la couche.

En outre, par la mise en oeuvre de l'invention, la variation de stoechiométrie en élément I par rapport à l'élément III atteinte sur le composé final I-III-VI, dans le cas d'une structure multicouche notamment, reste avantageusement inférieure à 4% et ce sur toute la surface de la couche.

La présente invention vise aussi une cellule photovoltaïque comprenant une couche mince d'un tel composé I-III-VI.

D'autres caractéristiques et avantages de l'invention apparaîtront à l'examen de la description détaillée ci-après, et des dessins annexés sur lesquels :
- la figure 1 représente schématiquement la configuration d'un agitateur d'un bain d'électrolyse pour la mise en oeuvre de l'invention, et
- la figure 2 illustre l'efficacité d'une cellule solaire obtenue par le procédé au sens de l'invention, en fonction de la brillance des couches obtenues,
- les figures 3A et 3B illustrent un agencement de bain d'électrolyse CU comportant une pluralité d'agitateurs AG1, ..., AGN,
- la figure 4 illustre l'influence du nombre prévu d'agitateurs (abscisses) sur la variation statistique (sur 140 mesures) de l'épaisseur de la couche électro-déposée (coefficient de variation en épaisseur, en pourcents (%), représenté en ordonnées),
- la figure 5 illustre l'influence du nombre prévu d'agitateurs (abscisses) sur une uniformité topographique liée à la réflectivité optique de la couche électro-déposée, et mesurée ici par niveau de gris (coefficient de variation en pourcents (%), représenté en ordonnées), et
- la figure 6 illustre l'influence du nombre prévu d'agitateurs (abscisses) sur le rendement faradique d'un dépôt d'indium (rendement comparé à un maximum, représenté en ordonnées).

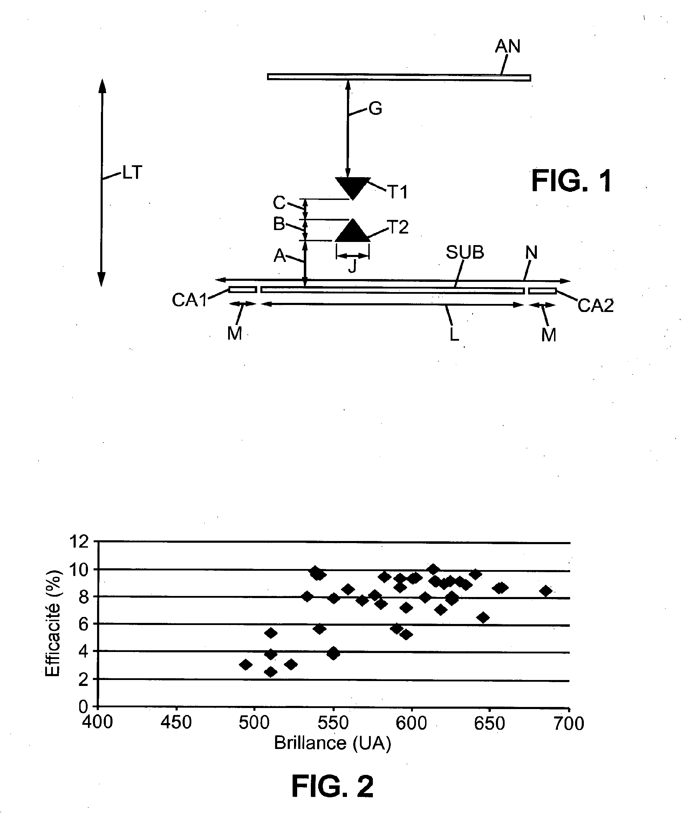

En référence à la figure 1, un substrat SUB est plongé dans un bain d'électrolyse en tant que cathode et une anode AN est disposée face au substrat, ce qui suscite un transport des sels d'élément I (tel le cuivre) et/ou d'élément III (tel l'indium) vers le substrat formant alors un dépôt d'une couche mince d'élément I ou d'élément III. Un agitateur T1, T2 se déplace parallèlement au substrat sur toute la longueur du substrat et toute sa largeur (référence L de la figure 1). Le déplacement est horizontal sur la figure 1. La dimension L est ici de 300 mm. Le substrat est bordé par un cadre CA1, CA2, de sorte que le mouvement de l'agitateur T1, T2 est d'amplitude N s'étendant au-delà du cadre. Par exemple, si les bords CA1, CA2 du cadre sont de largeur M de 100 mm, la course totale N de l'agitateur est de 535 mm.

L'agitateur présente en section en coupe (plan de la figure 1) deux triangles identiques T1 et T2, tête-bêche, la base du triangle T2 étant parallèle à la surface du substrat SUB. Cette base est de largeur J de 25 mm dans un exemple de réalisation. Sa hauteur B est de 25 mm. L'écart C entre les deux triangles est de 18 ou 19 mm.

L'agitateur (en particulier le triangle T2) est disposé à une distance A inférieure à 5 mm du substrat, préférentiellement 3 ou 4 mm avec les dimensions données ci-avant.

La base de l'autre triangle T1 est disposée à une distance G de 160 mm de l'anode AN. La largeur totale LT du bain d'électrolyse peut alors être de l'ordre de 350 mm.

Selon les essais réalisés, le balayage mécanique, préférentiellement opéré à une fréquence comprise entre 0,2 et 1,8 Hz, permet d'accroître, outre l'uniformité en épaisseur, l'homogénéité à l'échelle nanométrique.

Les propriétés de finesse de grains des matériaux déposés peuvent être estimées à l'aide d'une mesure en brillance de la couche déposée. A titre d'exemples tirés des essais réalisés, la rugosité de grain de la couche d'élément III, lorsque cette rugosité est d'une dimension moyenne :
- de 53 nm, influe sur la brillance de sorte que celle-ci est de l'ordre de 36% (sur une échelle de 0 à 100%), si la fréquence de balayage est de l'ordre de 0,25 Hz ;
- de 41 nm, influe sur la brillance de sorte que celle-ci est de l'ordre de 46% (sur une échelle de 0 à 100%), si la fréquence de balayage est de l'ordre de 0,5 Hz ;
- de 37 nm, influe sur la brillance de sorte que celle-ci est de l'ordre de 54% (sur une échelle de 0 à 100%), si la fréquence de balayage est de l'ordre de 0,75 Hz ;
- de 28 nm, influe sur la brillance de sorte que celle-ci est de l'ordre de 64% (sur une échelle de 0 à 100%), si la fréquence de balayage est de l'ordre de 1 Hz.

Il est alors démontré, en référence à la figure 2, le lien entre l'efficacité d'une cellule solaire comportant une couche I-III-VI (plus particulièrement de stoechiométrie exacte I-III-VI₂) dont les éléments I et III ont été déposés par le procédé au sens de l'invention (ordonnées) et la brillance mesurée, dans l'exemple représenté, sur la couche III (en abscisses).

Les mesures de brillance ont été effectuées avec un brillance-mètre à une longueur d'onde de 560 nm et une incidence de 60°. Les mesures topographiques de la rugosité des grains ont été effectuées avec un microscope à force atomique. Les mesures d'épaisseurs des couches pour l'estimation de la variation ont été réalisées par fluorescence X.

Ainsi, pour les cellules solaires en couches minces I-III-VI fabriquées par électro-dépôt, l'invention peut proposer d'adopter une approche qui permette d'évoluer vers des surfaces de grandes dimensions. On a fait évoluer ici un procédé utilisant une cellule verticale à agitateur, qui a pu être employée précédemment pour l'empilement de couches de semi-conducteurs et des systèmes microélectroniques (dont le principe est décrit notamment dans le document US-3,652,442), pour pouvoir traiter des cellules solaires à couche mince d'une superficie d'au moins 30 cm x 60 cm.

La cellule verticale à agitateur a permis l'obtention de couches minces uniformes sur un substrat de grande dimension, en optant, dans un exemple de réalisation, pour une approche à couches multiples d'élément I (tel Cu) et III (tel In) pour la fabrication de couches absorbantes I-III-VI (dites « CIS ») notamment de type p. En outre, le procédé ici permet de fabriquer une diode (telle qu'une cellule photovoltaïque) de grande dimension (adéquate pour un panneau solaire) en appliquant successivement des couches minces uniformes de matériaux différents, les unes sur les autres, puis en procédant à un recuit de ces couches minces en atmosphère d'élément VI par exemple, pour produire finalement le matériau de chalcopyrite I-III-VI₂.

On fabrique une diode de grande dimension par ajout séquentiel de couches minces uniformes. On assure le contrôle de la composition d'une couche CIS grâce à un contrôle précis de l'épaisseur des couches minces de Cu, In et éventuellement de gallium en tant qu'autre élément III possible (Ga). L'électrodéposition au sens de l'invention permet en effet un contrôle précis de l'épaisseur de couches ultraminces sur un substrat de grande dimension. Ce procédé séquentiel d'électrodéposition dans une cellule verticale à agitateur, par exemple pour l'électrodéposition de couches de Cu, In et Ga, est particulièrement avantageux, dès lors qu'il permet d'obtenir une diode électrique, telle qu'une cellule photovoltaïque ayant les propriétés illustrées sur la figure 2.

Un tel procédé comprend en pratique les étapes :
- placer une électrode arrière sur la face arrière d'un substrat de sorte que l'électrode arrière comporte une face de contact opposée à la face arrière du substrat ; et
- déposer une couche I ou III sur une première couche métallique (par exemple du molybdène) que porte la face avant du substrat, la couche I ou III ayant une uniformité d'épaisseur qui se situe à moins de 3% d'une épaisseur moyenne sur l'ensemble de la surface de cette couche.

Il s'agit en particulier de déposer au moins une couche I (par exemple du cuivre Cu) et au moins une couche III (par exemple de l'indium In et/ou du gallium Ga).

On peut prévoir ensuite l'étape consistant à :
- déposer une couche de type N comprenant un matériau semi-conducteur sur la couche I-III-VI finalement obtenue, la couche de type N formant une jonction de diode P-N avec la couche I-III-VI.

Le procédé peut se poursuivre encore par l'étape :
- déposer une couche conductrice transparente (typiquement du ZnO).

On peut prévoir que la diode électrique soit divisée en deux structures auxiliaires ou plus.

Le substrat comprend un ou plusieurs des matériaux suivants : verre, métal, feuille métallique, acier inoxydable, feuille de cuivre.

On peut prévoir en outre l'étape consistant à lisser le substrat avant de placer l'électrode arrière sur le substrat.

On peut prévoir en outre l'étape consistant à placer une couche formant barrière entre le substrat et la première couche métallique.

On peut prévoir ainsi les étapes :
- placer un substrat dans un support, le support ayant un élément formant écran voleur de courant (le cadre CA1, CA2 précité) qui borde au moins deux côtés du substrat SUB, le support comportant une électrode de support, le substrat comportant une électrode arrière sur une surface du substrat ;
- placer le support avec le substrat dans une première cuve, la première cuve ayant une première électrode de cuve, la première cuve contenant en outre un électrolyte de cuivre ;
- exciter l'électrode de support et la première électrode de cuve en leur appliquant une différence de potentiel, tout en maintenant la densité de courant dans l'écran voleur de courant à une première densité de courant d'écran voleur de courant et la densité de courant dans l'électrode arrière à une densité de courant arrière ;
- déplacer de manière répétée un agitateur à travers le premier électrolyte sur la surface de l'électrode arrière à une première distance d'agitateur par rapport à l'électrode arrière, une première couche métallique étant électrodéposée sur l'électrode arrière, de sorte que la couche métallique de cuivre est électrodéposée avec une première uniformité d'épaisseur qui se situe à moins de 3% d'une première épaisseur moyenne sur l'ensemble de la surface de la couche métallique de cuivre ;
- placer le substrat avec son support (qui peut être le même que le premier support précité) dans une deuxième cuve, la deuxième cuve ayant une deuxième électrode de cuve, la deuxième cuve contenant en outre un électrolyte d'indium ;
- exciter la deuxième électrode de support et la deuxième électrode de cuve en leur appliquant une différence de potentiel tout en maintenant la densité de courant dans le deuxième écran voleur de courant à une deuxième densité de courant d'écran voleur de courant et la densité de courant dans la couche métallique de cuivre à une densité de courant de couche métallique de cuivre ;
   et
- déplacer de manière répétée éventuellement un autre agitateur à travers l'électrolyte d'indium sur la surface de la couche métallique de cuivre à une deuxième distance d'agitateur par rapport au substrat, une couche métallique d'indium étant électrodéposée sur la couche métallique de cuivre, de sorte que la couche métallique d'indium est électrodéposée avec une deuxième uniformité d'épaisseur qui se situe à moins de 3% d'une épaisseur moyenne sur l'ensemble de la surface de la couche métallique d'indium.

On dépose ainsi successivement une couche de cuivre, puis une couche d'indium.

On peut en outre :
- placer le substrat avec son support (qui peut être le même que le premier support précité) dans une troisième cuve, la troisième cuve ayant au moins une troisième électrode de cuve, la troisième cuve contenant en outre un électrolyte de gallium ;
- exciter la troisième électrode de support et la troisième électrode de cuve en leur appliquant une différence de potentiel tout en maintenant la densité de courant dans le troisième écran voleur de courant à une troisième densité de courant d'écran voleur de courant et la densité de courant dans la couche métallique d'indium à une deuxième densité de courant de métal ; et
- déplacer de manière répétée un troisième agitateur à travers l'électrolyte de gallium sur la surface de la couche métallique d'indium à une troisième distance d'agitateur par rapport à la couche métallique d'indium, une couche métallique de gallium étant électrodéposée sur la couche métallique d'indium, de sorte que la couche métallique de gallium est électrodéposée avec une troisième uniformité d'épaisseur qui se situe à moins de 3% d'une épaisseur moyenne sur l'ensemble de la surface de la couche métallique de gallium.

On dépose alors ainsi une troisième couche, maintenant de gallium.

On peut bien entendu prévoir :
- qu'au moins deux des éléments suivants soient identiques la première cuve, la deuxième cuve et la troisième cuve,
- et/ou qu'au moins deux des éléments suivants soient identiques : la première électrode de cuve, la deuxième électrode de cuve et la troisième électrode de cuve,
- et/ou qu'au moins deux des éléments suivants soient identiques : le premier agitateur, le deuxième agitateur et le troisième agitateur.

L'électrode arrière peut être composée d'un des éléments suivants : molybdène, molybdène cuivre, alliage de molybdène, double couche avec du molybdène comme première couche et une deuxième couche conductrice de cuivre et/ou d'indium.

On peut appliquer une première densité de courant d'écran (voleur de courant) se situant entre la densité de courant dans l'électrode arrière et une densité de courant arrière (notamment dans une réalisation où un cadre est prévu pour « voler du courant », c'est-à-dire de détourner du courant pour éviter que les bords du substrat altèrent les lignes de champs dérivées de la différence de potentiel avec l'anode). On comprendra ainsi que l'on peut moduler la densité de courant appliquée au cadre par rapport à celle appliquée à au substrat.

On peut alors mettre en oeuvre les étapes :
- appliquer la première densité de courant d'écran (voleur de courant) se situant entre 0,5 mA/cm² et 100 mA/cm² et la densité de courant dans l'électrode arrière à une densité de courant arrière se situe entre 0,5 mA/cm² et 100mA/cm² ;
- obtenir une première uniformité d'épaisseur qui se situe à moins de 3% d'une première épaisseur moyenne sur l'ensemble de la surface de la première couche métallique ;
- appliquer une deuxième densité de courant d'écran voleur de courant et la densité de courant dans la première couche métallique à une première densité de courant de couche métallique ;
- déplacer de manière répétée un deuxième agitateur à une fréquence comprise entre 0,2 Hz à 1,8 Hz, à une deuxième distance d'agitateur par rapport au substrat ;
- obtenir une deuxième uniformité d'épaisseur qui se situe à moins de 3% d'une épaisseur moyenne sur l'ensemble de la surface de la deuxième couche métallique ;
- appliquer une troisième densité de courant d'écran voleur de courant et la densité de courant dans la deuxième couche métallique à une deuxième densité de courant de métal ;
- déplacer de manière répétée un troisième agitateur à travers le troisième électrolyte à une fréquence de 0,3 Hz à 1,8 Hz ;
- électrodéposer une troisième couche métallique (par exemple de gallium) avec une troisième uniformité d'épaisseur qui se situe à moins de 3% d'une épaisseur moyenne sur l'ensemble de la surface de la troisième couche métallique.

Bien entendu, la présente invention ne se limite pas aux formes de réalisation décrites ci-avant à titre d'exemple ; elle s'étend à d'autres variantes.

Ainsi, sur la figure 1, il a été représenté que le substrat serait placé dans une ou plusieurs des cuves verticalement. En variante, il peut tout aussi bien être placé horizontalement.

Par ailleurs, on a décrit ci-avant un agitateur comportant un couple de triangles inversés, comme représenté sur la figure 1. Bien entendu, l'agitateur peut comporter plus d'un couple de triangles, les bases des triangles étant au moins parallèles d'un couple à l'autre.

On décrit ci-après les détails d'une telle réalisation.

Notamment pour des tailles de substrats strictement,supérieures à 30 cm x 60 cm, il s'est avéré que les performances du dépôt assisté par un agitateur au sens de l'invention pouvaient être améliorées en utilisant une pluralité d'agitateurs. L'utilisation de plusieurs agitateurs permet, comme présenté ci-après, de garantir une uniformité et une qualité de dépôt compatible avec la réalisation de cellules photovoltaïques à base de matériau I-III-VI.

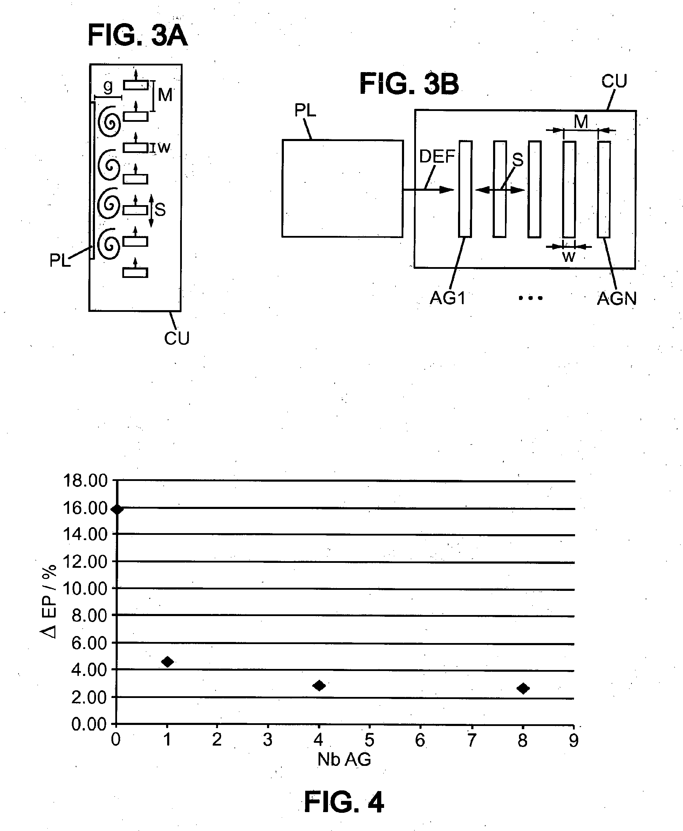

En particulier, des essais ont été réalisés pour l'électro-dépôt d'indium sur cuivre. Des plaques (formant « électrodes » de dépôt) de dimensions 60 cm x 120 cm sont placées sur un convoyeur défilant à une vitesse comprise entre 0,5 et 2 mètres par minute, par exemple de l'ordre de 1 mètre par minute, dans un bain (ou « cuve ») d'électrolyse, face de dépôt vers le bas. Comme représenté sur les figures 3A et 3B, les 120 cm de la plaque PL sont comptés dans son sens de défilement (flèche DEF) dans la cuve CU. La longueur de la cuve d'électrolyse est de 90 cm et la cuve comporte une pluralité d'agitateurs AG1, ..., AGN. Les agitateurs ont chacun un mouvement de va-et-vient (d'amplitude S), perpendiculaire à leur grand axe et parallèle à la direction de déplacement DEF de la plaque. En particulier, le mouvement de va-et-vient des agitateurs est en phase, de même vitesse et de même amplitude.

Il s'est avéré qu'il convient néanmoins d'optimiser les paramètres de l'agitation car l'uniformité topographique (de surface) et d'épaisseur locale dépend fortement de ces paramètres. Par exemple, des traces, parallèles aux grands axes des agitateurs, peuvent apparaitre sur les dépôts. Ces traces sont liées à la formation de turbulences stationnaires locales, induites par chaque agitateur. Un vortex engendré par chaque agitateur interagit avec le vortex généré par les autres agitateurs et peut conduire à des phénomènes d'écrantage ayant un impact sur l'épaisseur locale d'une « couche » d'interaction entre le matériau à déposer sous forme ionique (par exemple In³⁺) et notamment les électrons appliqués pour favoriser l'électrolyse. Cette couche est appelée « couche limite de diffusion ». Il convient de définir en outre un paramètre de caractérisation de l'efficacité de l'électrolyse, appelé « rendement faradique ». Il s'agit d'un ratio entre la quantité de matériau effectivement électro-déposée et la quantité de matériau électro-déposé attendue d'après la charge correspondant au courant ayant circulé entre les électrodes pendant l'électrolyse.

Des inhomogénéités de cette couche ont alors un impact sur la topographie locale de la couche finalement électro-déposée, et par conséquent sur ses propriétés électriques. Pour pallier les phénomènes d'écrantage précités, il convient de choisir avec soin les paramètres de mouvement des agitateurs dont, en référence aux figures 3A et 3B :
- leur amplitude de mouvement S,
- la vitesse de mouvement,
- la largeur W de chaque agitateur (prise par exemple à la base d'un triangle),
- la distance M entre deux agitateurs consécutifs (centre à centre).

Dans un exemple de réalisation, la distance M est de l'ordre de 100 mm ou 200 mm. Chaque agitateur présente la géométrie en double triangle décrite précédemment. La distance g entre les agitateurs et l'électrode de dépôt (figure 2A) est de 2 mm.

Plus particulièrement, les essais réalisés montrent des résultats satisfaisants dans les conditions suivantes :
- l'amplitude S de mouvement de chaque agitateur est supérieure à la distance M entre deux agitateurs consécutifs moins une épaisseur W d'agitateur, et préférentiellement inférieure à deux fois la distance M entre les agitateurs ; il a été observé que si l'amplitude est inférieure à cette plage, le rendement faradique de dépôt de l'indium chute et l'aspect de la plaque devient « laiteux » ; à titre d'exemple de réalisation ayant permis d'atteindre les résultats présentés ci-après en référence aux figures 4 à 6, l'amplitude S peut être de 140 mm ;
- la vitesse de chaque agitateur est supérieure à une amplitude de mouvement S, par seconde, et préférentiellement inférieure ou égale à 0,2 m/s ; il a été observé que là durée « efficace » de la turbulence générée par chaque agitateur est d'environ 2 secondes, de sorte que, pour renouveler une turbulence efficace, une vitesse de mouvement des agitateurs supérieure à l'amplitude S par seconde est préférable ; au-delà de 0,2 m/s, la turbulence génère un vortex ne permettant plus d'obtenir des dépôts uniformes ; dans un exemple de réalisation ayant permis d'atteindre les résultats présentés ci-après en référence aux figures 4 à 6, la vitesse de balayage est de 0,16 m/s ;

- l'opération de balayage mécanique peut mettre en oeuvre au moins deux agitateurs et préférentiellement au moins quatre agitateurs, pour une plaque de dimensions de 60 cm x 120 cm, et dans un exemple de réalisation ayant permis d'atteindre certains des résultats présentés ci-après en référence aux figures 4 à 6, huit agitateurs;
- la distance M entre deux agitateurs consécutifs est de 100 mm pour huit agitateurs et de 200 mm pour quatre agitateurs, dans les exemples de réalisation dont les résultats sont présentés ci-après.

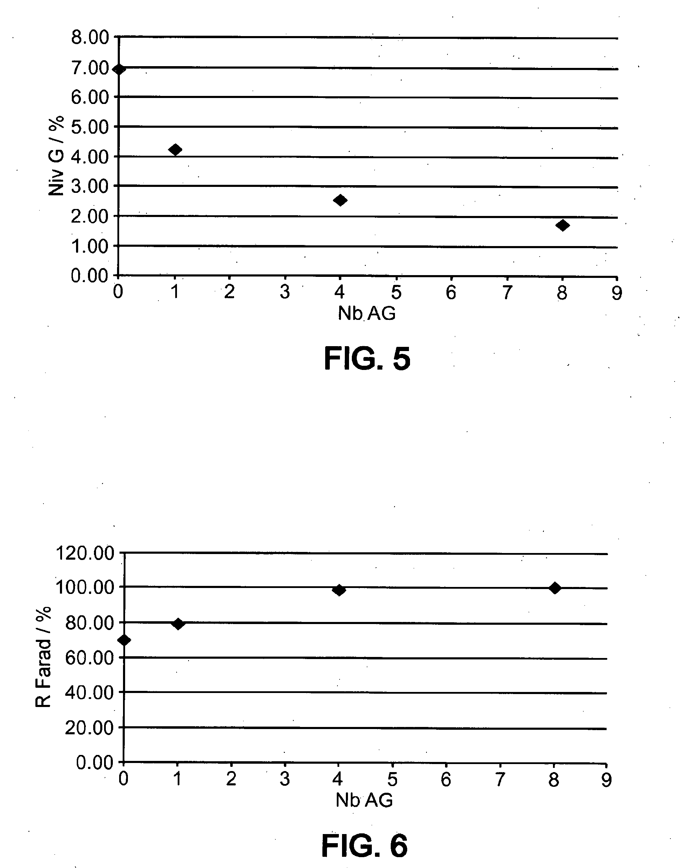

Les résultats obtenus sont satisfaisants. Il a été observé en particulier :
- une uniformité d'épaisseur de couche électro-déposée (mesurée par fluorescence X) avec un coefficient de variation inférieur à 3%, comme le montre la figure 4,
- une uniformité topographique (mesurée par niveau de « gris », lié à la réflectivité de la couche, selon donc un aspect optique) avec un coefficient de variation inférieur à 2% en particulier pour huit agitateurs, comme le montre la figure 5,
- une distance entre les « traces » hydromécaniques précitées inférieure à 3 cm, si elle est toutefois identifiable.

En référence à la figure 4, il apparaît que quatre agitateurs déjà, pour une plaque de 60 cm x 120 cm, permet d'obtenir un coefficient de variation de l'uniformité d'épaisseur d'indium inférieur à 3% (3% étant la valeur limite de coefficient de variation par élément Cu, In et Ga, compatible avec une réalisation satisfaisante d'un module photovoltaïque). Ces données ont été mesurées par fluorescence X en 140 points de mesure répartis uniformément sur toute la surface de la plaque.

La figure 6 présente le rendement faradique de dépôt d'indium obtenu avec plusieurs agitateurs, comparativement à l'utilisation d'un seul agitateur. Il est supérieur à 80% (normalisé par rapport au meilleur rendement faradique obtenu). Si ce rendement est inférieur à 80%, l'aspect de la plaque devient laiteux, lié à une mauvaise évacuation d'hydrogène formé pendant l'électrolyse. En effet, une réaction de formation d'hydrogène vient en compétition de la réaction de dépôt d'indium et il convient d'évacuer l'hydrogène pour ne pas gêner l'électro-dépôt d'indium. Plus précisément, l'électrolyse de l'indium est en compétition avec celle de l'eau qui conduit à la formation d'hydrogène gazeux. Sans une agitation efficace, cet hydrogène n'est pas évacué de la surface et diminue donc la fraction de surface d'électrode accessible pour le dépôt d'indium.

Avantageusement, la multiplication du nombre d'agitateurs Nb AG conduit donc à une augmentation du rendement faradique de dépôt de l'indium (de 30% pour un passage d'aucun agitateur à quatre agitateurs).

Ainsi, en augmentant le nombre d'agitateur par unité de longueur de cuve, un gain important en uniformité latérale d'épaisseur peut être obtenu.

Les résultats présentés ci-dessus sont compatibles avec la réalisation de cellules photovoltaïques performantes en termes de rendement, à base de matériau I-III-VI.

Ils ont été décrits pour l'indium mais ont été obtenus avec des paramètres dans les mêmes gammes pour le gallium et des paramètres très voisins pour le cuivre.

## Revendications

1. Procédé de fabrication d'un composé I-III-VI pour des applications photovoltaïques, sous forme de couche mince, où l'élément I désigne le cuivre, l'élément III désigne l'indium et/ou le gallium et l'élément VI désigne le soufre et/ou le sélénium, comprenant les étapes :
a) électro-déposer une structure de couche mince d'éléments I et/ou III sur la surface d'une électrode (SUB), et
b) incorporer au moins un élément VI dans la structure pour obtenir le composé I-III-VI,
**caractérisé en ce que** l'étape d'électro-dépôt a) comporte une opération de balayage mécanique pour contrôler une épaisseur de couche mince à moins de 3% de variation en uniformité d'épaisseur sur toute la surface de l'électrode recevant le dépôt,
**en ce que** l'opération de balayage mécanique met en oeuvre au moins deux agitateurs de bain d'électrolyse devant la surface de l'électrode, les deux agitateurs ayant des mouvements en phase, rectilignes et de va-et-vient parallèlement à la surface de l'électrode, de même vitesse et de même amplitude,
et **en ce que**, chaque agitateur ayant une épaisseur prédéterminée et les agitateurs étant espacés d'une distance prédéterminée, l'amplitude de mouvement de chaque agitateur est supérieure à la distance entre les agitateurs moins une épaisseur d'agitateur, et inférieure à deux fois la distance entre les agitateurs.

2. Procédé selon la revendication 1, **caractérisé en ce que** chaque agitateur comporte une section en coupe présentant au moins deux triangles inversés (T1, T2), la base du triangle le plus proche de l'électrode (T2) étant parallèle à la surface de l'électrode (SUB).

3. Procédé selon l'une des revendications précédentes, **caractérisé en ce que** les dimensions de l'électrode sont supérieures ou de l'ordre de 700 cm².

4. Procédé selon l'une des revendications précédentes, **caractérisé en ce que** le balayage mécanique est opéré à une fréquence comprise entre 0,2 et 1,8 Hz.

5. Procédé selon l'une des revendications précédentes, **caractérisé en ce que** chaque agitateur est disposé à une distance inférieure à 5 mm de l'électrode.

6. Procédé selon l'une des revendications précédentes, **caractérisé en ce que** l'électrode est bordée par un cadre (CA1, CA2), et **en ce que** le mouvement de l'ensemble des deux agitateurs est d'amplitude s'étendant au-delà du cadre.

7. Procédé selon l'une des revendications précédentes, **caractérisé en ce que** la vitesse de chaque agitateur est supérieure à une amplitude de mouvement, par seconde.

8. Procédé selon l'une des revendications précédentes, **caractérisé en ce que** la vitesse de chaque agitateur est inférieure ou égale à 0,2 m/s.

9. Procédé selon l'une des revendications précédentes, **caractérisé en ce que** ladite électrode est déplacée dans le bain d'électrolyse dans une direction parallèle au mouvement de va-et-vient de chaque agitateur, à une vitesse comprise entre 0,5 et 2 mètres par minute.

10. Procédé selon l'une des revendications précédentes, **caractérisé en ce que** l'opération de balayage mécanique met en oeuvre au moins quatre agitateurs, pour une plaque de dimensions de 60 cm x 120 cm, les 120 cm étant comptés dans le sens de mouvement de va-et-vient des agitateurs.

11. Composé I-III-VI pour des applications photovoltaïques, sous forme de couche mince, où l'élément I désigne le cuivre, l'élément III désigne l'indium et/ou le gallium et l'élément VI désigne le soufre et/ou le sélénium, obtenu par le procédé selon l'une des revendications précédentes et **caractérisé en ce qu'**il comporte moins de 3% de variation en uniformité d'épaisseur sur toute la surface de la couche.

12. Composé I-III-VI selon la revendication 11, **caractérisé en ce qu'**il comporte moins de 4% de variation en stoechiométrie en élément I par rapport à l'élément III, sur toute la surface de la couche.

13. Composé I-III-VI selon l'une des revendications 11 et 12, **caractérisé en ce que** la couche mince présente une rugosité de grains inférieure ou de l'ordre de 50 nanomètres.

14. Cellule photovoltaïque comprenant une couche mince de composé I-III-VI selon l'une des revendications 11 et 12, où l'élément I désigne le cuivre, l'élément III désigne l'indium et/ou le gallium et l'élément VI désigne le soufre et/ou le sélénium.

## Patentansprüche

1. Verfahren zur Herstellung einer I-III-VI-Verbindung für Photovoltaik-Anwendungen in Form einer Dünnschicht, wobei das Element I für Kupfer steht, das Element III für Indium und/oder Gallium steht und das Element VI für Schwefel und/oder Selen steht, wobei es die folgenden Schritte umfasst:
a) galvanotechnisches Abscheiden einer Dünnschichtstruktur aus den Elementen I und/oder III auf der Oberfläche einer Elektrode (SUB), und
b) Einfügen mindestens eines Elements VI in die Struktur, um die I-III-VI-Verbindung zu erhalten,
**dadurch gekennzeichnet, dass** der Schritt des galvanotechnischen Abscheidens a) einen Vorgang des mechanischen Abtastens aufweist, um sicherzustellen, dass die Dünnschicht eine Dicke aufweist, die über die gesamte Oberfläche der Elektrode, welche als Grundlage des Abscheidevorgangs dient, so gleichförmig ist, dass die Dickenschwankung geringer als 3 % bleibt,
dadurch, dass bei dem mechanischen Abtastvorgang vor der Oberfläche der Elektrode mindestens zwei Elektrolysebadrührer eingesetzt werden, wobei die beiden Rührer sich phasengleich, geradlinig sowie parallel zur Oberfläche der Elektrode mit derselben Geschwindigkeit und derselben Amplitude hin- und herbewegen,
und dadurch, dass die Rührer jeweils eine vorbestimmte Dicke haben und die Rührer in einem vorbestimmten Abstand voneinander angeordnet sind, wobei die Bewegungsamplitude jedes der Rührer größer als der Abstand zwischen den Rührern abzüglich einer Rührerdicke sowie kleiner als das Doppelte des Abstands zwischen den Rührern ist.

2. Verfahren nach Anspruch 1, **dadurch gekennzeichnet, dass** die Rührer jeweils einen Querschnitt aufweisen, der mindestens zwei umgekehrte Dreiecke (T1, T2) aufweist, wobei die Basis des Dreiecks (T2), welches der Elektrode am nächsten ist, parallel zur Oberfläche der Elektrode (SUB) ist.

3. Verfahren nach einem der vorhergehenden Ansprüche, **dadurch gekennzeichnet, dass** die Abmessungen der Elektrode in der Größenordnung von 700 cm² oder darüber liegen.

4. Verfahren nach einem der vorhergehenden Ansprüche, **dadurch gekennzeichnet, dass** das mechanische Abtasten mit einer Frequenz erfolgt, die im Bereich von 0,2 bis 1,8 Hz liegt.

5. Verfahren nach einem der vorhergehenden Ansprüche, **dadurch gekennzeichnet, dass** die Rührer jeweils in einem Abstand von weniger als 5 mm von der Elektrode angeordnet sind.

6. Verfahren nach einem der vorhergehenden Ansprüche, **dadurch gekennzeichnet, dass** die Elektrode von einem Rahmen (CA1, CA2) umgeben ist, und dadurch, dass die Bewegung der beiden Rührer insgesamt eine Amplitude hat, die sich über den Rahmen hinaus erstreckt.

7. Verfahren nach einem der vorhergehenden Ansprüche, **dadurch gekennzeichnet, dass** die Geschwindigkeit jedes der Rührer größer als eine Bewegungsamplitude pro Sekunde ist.

8. Verfahren nach einem der vorhergehenden Ansprüche, **dadurch gekennzeichnet, dass** die Geschwindigkeit jedes der Rührer höchstens 0,2 m/s beträgt.

9. Verfahren nach einem der vorhergehenden Ansprüche, **dadurch gekennzeichnet, dass** die Elektrode in dem Elektrolysebad in einer Richtung verschoben wird, die parallel zur Hin- und Herbewegung jedes der Rührer ist, mit einer Geschwindigkeit, welche im Bereich von 0,5 bis 2 Metern pro Minute liegt.

10. Verfahren nach einem der vorhergehenden Ansprüche, **dadurch gekennzeichnet, dass** beim Vorgang des mechanischen Abtastens mindestens vier Rührer eingesetzt werden, für eine Platte mit Abmessungen von 60 cm x 120 cm, wobei die 120 cm in Richtung der Hin- und Herbewegung der Rührer gemessen werden.

11. I-III-VI-Verbindung für Photovoltaik-Anwendungen, in Form einer Dünnschicht, wobei das Element I für Kupfer steht, das Element III für Indium und/oder Gallium steht und das Element VI für Schwefel und/oder Selen steht,
erhalten mittels des Verfahrens nach einem der vorhergehenden Ansprüche und **dadurch gekennzeichnet, dass** sie über die gesamte Oberfläche der Schicht so gleichförmig ist, dass sie eine Dickenschwankung von weniger als 3 % aufweist.

12. I-III-VI-Verbindung nach Anspruch 11, **dadurch gekennzeichnet, dass** sie hinsichtlich des stöchiometrischen Verhältnisses zwischen dem Element I und dem Element III derart beschaffen ist, dass sie über die gesamte Oberfläche der Schicht eine Schwankung von weniger als 4 % aufweist.

13. I-III-VI-Verbindung nach einem der Ansprüche 11 und 12, **dadurch gekennzeichnet, dass** die Dünnschicht eine Kornrauheit aufweist, die in der Größenordnung von 50 Nanometer oder darunter liegt.

14. Photovoltaik-Zelle, die eine Dünnschicht aus einer I-III-VI-Verbindung nach einem der Ansprüche 11 und 12 umfasst, wobei das Element I für Kupfer steht, das Element III für Indium und/oder Gallium steht und das Element VI für Schwefel und/oder Selen steht.

## Claims

1. Manufacturing process for a I-III-VI compound for photovoltaic applications, in thin layer form, including the steps of:
a) electrodeposition of a layer structure comprising elements I and/or III, on the surface of an electrode (SUB), and
b) incorporating at least one element VI in the structure to obtain the I-III-VI compound, **characterized in that** the electrodeposition step a) comprises an operation of mechanical sweeping to control the layer thickness to less than 3% variation in uniformity of thickness over the entire surface of the electrode receiving the deposition,
**in that** the mechanical sweeping operation involves at least two electrolytic bath stirrers in front of the surface of the electrode, the two stirrers having phased back-and-forth movements parallel to the surface of the electrode, having the same speed and same amplitude,
and **in that**, each stirrer having a predetermined thickness and the stirrers being spaced by a predetermined distance, the movement amplitude of each stirrer is greater than the distance between the stirrers less one stirrer thickness, and less than twice the distance between the stirrers.

2. Process according to claim 1, **characterized in that** each stirrer comprises a cross-section having two inverted triangles (T1, T2) where the base of the triangle closest to the electrode (T2) is parallel to the surface of the electrode (SUB).

3. Process according to anyone of the preceding claims, **characterized in that** the dimensions of the electrode are greater than or in the region of 700 cm².

4. Process according to anyone of the preceding claims, **characterized in that** the mechanical sweeping is operated at a frequency included between 0.2 and 1.8 Hz.

5. Process according to anyone of the preceding claims, **characterized in that** each stirrer is arranged at a distance of less than 5 mm from the electrode.

6. Process according to anyone of the preceding claims, **characterized in that** the electrode is bounded by a frame (CA1, CA2) and **in that** the amplitude of the movement of the whole set of stirrers extends beyond the frame.

7. Process according to any one of the preceding claims, **characterized in that** the speed of each stirrer is greater than one movement amplitude, per second.

8. Process according to any one of the preceding claims, **characterized in that** the speed of each stirrer is less than or equal to 0.2 m/s.

9. Process according to any one of the preceding claims, **characterized in that** said electrode is moved in the electrolysis bath in a direction parallel to the back-and-forth movement of each stirrer, at a speed between 0.5 and 2 meters per minutes.

10. Process according to any one of the preceding claims, **characterized in that** the mechanical sweeping operation involves at least four stirrers, for a plate having the dimensions 60 cm x 120 cm, the 120 cm being counted in the direction of the back-and-forth movement of the stirrers.

11. I-III-VI compound for photovoltaic applications, in thin layer form, where element I refers to copper, element III refers to indium and/or gallium and element VI refers to sulfur and/or selenium, obtained by the process according to any one of the preceding claims, and **characterized in that** it comprises less than 3% variation in uniformity of thickness over the entire layer surface.

12. I-III-VI compound according to claim 11, **characterized in that** it comprises less than 4% variation in stoichiometry of element I relative to element III over the entire layer surface.

13. Process according to anyone of claims 11 and 12, **characterized in that** the layer structure has a grain roughness less than or of order 50 nanometers.

14. Photovoltaic cell comprising a thin layer of a I-III-VI compound according to any one of claims 11 and 12, where element I refers to copper, element III refers to indium and/or gallium and element VI refers to sulfur and/or selenium.
